Europäisches Patentamt

European Patent Office

Office européen des brevets

(11) Publication number: **0 239 250**
A2

# EUROPEAN PATENT APPLICATION

(21) Application number: 87301674.5

(22) Date of filing: 25.02.87

(51) Int. Cl.⁴: **H01L 29/60** , H01L 29/78 , H01L 29/08

---

The title of the invention has been amended (Guidelines for Examination in the EPO, A-III, 7.3).

(30) Priority: 28.02.86 JP 42940/86

(43) Date of publication of application:
30.09.87 Bulletin 87/40

(84) Designated Contracting States:
DE FR GB

(71) Applicant: **Kabushiki Kaisha Toshiba
72, Horikawa-cho Saiwai-ku
Kawasaki-shi Kanagawa-ken 210(JP)**

(72) Inventor: **Morita, Shigeru c/o Patent Division
Toshiba
Corporation Principal Office 1-1 Shibaura
1-chome
Minato-ku Tokyo(JP)**

(74) Representative: **Freed, Arthur Woolf et al
MARKS & CLERK 57-60 Lincoln's Inn Fields
London WC2A 3LS(GB)**

---

(54) **Short channel MOS transistor.**

(57) An MOS semiconductor device comprising a semiconductor substrate (11) and an element region in the semiconductor substrate (11) which is separated from other regions by an element separation region (12). A MOSFET transistor has a pair of impurity diffusion regions, which are separated from one another in the semiconductor substrate (11) and constitute source and drain regions (14, 15) separated by a channel region (20), and a gate electrode (23) constituted by a stack structure consisting of a gate insulation layer (21) and a gate electrode conductor (22). The lengths of the gate electrode (23) and the separation region (20) between the source and drain regions (14, 15), in the vicinity of a central portion of a channel region (22) are shorter than the lengths of the gate electrode (23) and the channel region (20) in the vicinities of channel region (22) bounding the element separation region (12).

## MOS semiconductor device

The present invention relates to a MOS semiconductor device. More particularly, the invention relates to a MOS semiconductor device which is provided with a so-called short channel MOS transistor having an extremely short channel length to achieve a very small element size.

A trend in recent MOS semiconductor devices, has been to reduce the effective channel length of incorporated MOS transistors to achieve faster operating speeds and higher element density, etc. However, the reduction of effective channel length in these semiconductor devices has been accompanied by problems of reduced reliability. Specific aspects of this reduction of reliability are a lowering of conductance and an increase in threshold voltage with elapse of transistor operating time. Phenomena such as this occur as follows. Reduction of effective channel length is accompanied by concentration of an electric field and increased field intensity in the vicinity of the drain. Electrons, that are accelerated by this field and store a high level of energy, strike the silicon lattice of the channel region. High energy electrons, called hot electrons that are produced by this impact, become trapped in the gate insulation layer.

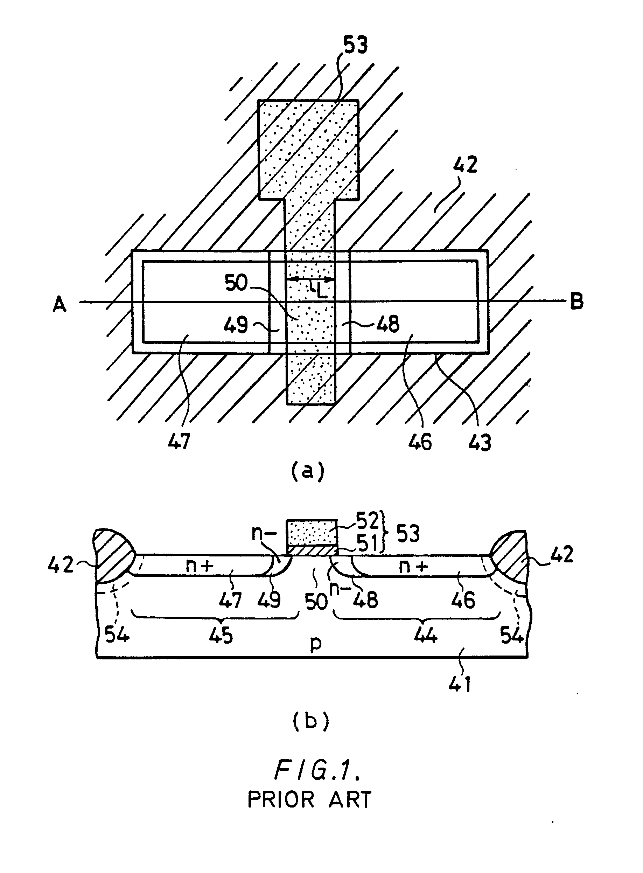

A measure that has been adopted in the past to counter this has been to use a transistor having a drain region with a double structure, such as typified by an LDD (lightly doped drain) structure, for example. A transistor such as this is formed by controlling the impurity concentration profile in the direction of depth of the drain diffusion region and in the transverse direction. An example of an LDD structure is shown in Fig. 1. Fig. 1(a) is a plan view of the transistor pattern and Fig. 1(b) is a section along the line A-B of Fig. 1(a). In the figure, element regions 43 are separated by a field insulation layer 42 in a p type silicon semiconductor substrate 41, for example. Field insulation layer 42 is indicated by the hatched line portion in the figure. Within an element region 43, a source region 44 and a drain region 45 that are separated from one another are formed by n impurity diffusion in the substrate. Source region 44 and drain region 45 are respectively constituted by $n^+$ regions 46 and 47 with a comparatively high impurity concentration and $n^-$ regions 48 and 49 with a comparatively low impurity concentration. The comparatively low impurity concentration $n^-$ regions 48 and 49 are disposed adjacent a channel region 50 which is formed between source region 44 and drain region 45 and on which a very thin gate insulation layer 51 is formed by thermal oxidation of silicon or similar procedure. On top of gate insulation layer 51, there is provided a gate electrode conductor 52 which is, e.g., constituted by polycrystalline silicon that has its resistance lowered by inclusion of an impurity. Gate insulation layer 51 and gate electrode conductor 52 together constitute a gate electrode 53 with a stack structure. In the portion of substrate 41 that lies below field insulation layer 42, there is formed an anti-inversion layer 54 containing a p type impurity. It is seen from the drawing that above channel region 50, the length (indicated by L in the drawing) of gate electrode 53 in the direction of disposition of source and drain regions 44 and 45 is uniform in this transistor.

In a MOS transistor with an LDD structure, the field concentration is suppressed by providing comparatively low impurity concentration $n^-$ region 49 in drain region 45 adjacent to gate electrode 53 and providing comparatively high impurity concentration $n^+$ region 47 at a distance from gate electrode 53.

An MOS transistor with an LDD structure is disclosed in "Design and Characteristics of the Lightly Doped Drain-Source (LDD) Insulated Gate Field-Effect Transistor" in IEEE Transactions on Electron Devices Volume ED-27 Nos 8 pp 1359 to 1367.

However, even with a transistor in which this countermeasure has been adopted, it is not possible to avoid a fall in reliability when the effective channel length is made still smaller.

In the past, even elements in which the abovedescribed countermeasure for short channels is adopted are associated with the problem that further reduction of the effective channel length leads to reduced reliability.

An object of this invention is to provide a MOS semiconductor device which permits maintenance of satisfactorily high reliability even if the effective channel length is made still shorter.

According to this invention, there is provided an MOS semiconductor device comprising:
a semiconductor substrate; and
a MOS transistor having a pair of impurity diffusion regions which are separated from one another in the semiconductor substrate and constitute source and drain regions separated by a channel region, and a gate electrode constituted by a stack structure consisting of a gate insulation layer and a gate conductive layer, the MOS transistor being surrounded by an element separating region; characterised in that
the lengths of the gate electrode and the channel region between the source and drain regions in the vicinity of a central portion of the channel region are shorter than the lengths of the gate electrode and the channel region in the vicinities of channel region bounding the element separation region.

Embodiments of this invention will now be described, by way of example, with reference to the accompanying drawings of which:-

Fig 1(a) and Fig 1(b) show a plan view of the pattern and a cross-section of a known device;

Fig 2 shows the structure of one embodiment of the invention, Fig 2(a) being a plan view of the pattern and Fig 2(b) and Fig 2(c) cross-sections;

Fig 3 shows the structure of another embodiment of the invention, Fig 3(a) being a plan view of the pattern and Fig 3(b) a cross-section; and

Fig 4 to Fig 6 are characteristic plots.

Embodiments of the invention will now be described with reference to the drawings.

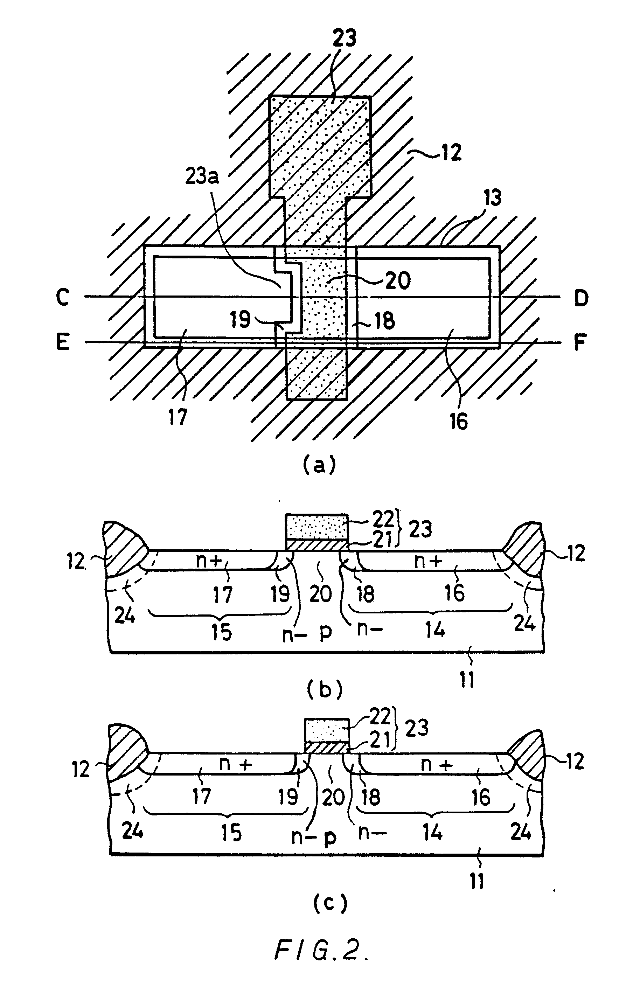

Fig 2 shows the structure of one embodiment of a MOS semiconductor device according to the invention. Fig 2(a) is a plan view of the pattern of this device. Fig 2(b) is a section along the line E-F of Fig 2(a). Fig 2(c) is a section along the line C-D of Fig 2(a). In the figure, for example, a p type (100) silicon semiconductor substrate 11 has a resistivity of 0.3 (ohm cm). In substrate 11, an element region 13 is isolated by a field insulation layer 12, indicated by the hatched line portion in the figure. Field insulation layer 12 is about 5000 (Angstrom) thick. Within this element region 13, a mutually separated source region 14 and drain region 15 are formed by n impurity diffusion in substrate 11. Source region 14 and drain region 15 are each formed by an $n^+$ region, 16 and 17, with a comparatively high impurity concentration, e.g., about $1.6 \times 10^{20}$ cm$^{-3}$, and $n^-$ regions, 18 and 19, with a comparatively low impurity concentration, e.g., about $2 \times 10^{18}$ cm$^{-3}$. N$^-$ regions 18 and 19 are formed so that they are adjacent a channel region 20 defined between source region 14 and drain region 15. A very thin, e.g., about 200 (Angstrom), gate insulation layer 21 is formed on top of channel region 20 by thermal oxidation of silicon or similar procedure. A gate electrode conductor 22 is formed on top of gate insulation layer 21. Gate electrode conductor 22 is constituted by polycrystalline silicon that has a layer thickness of around 4000 (Angstrom) and is made low-resistance by the inclusion of an impurity. Gate insulation film 21 and gate electrode conductor 22 together form a gate electrode 23 with a stack structure. An anti-inversion layer 24 in which around $1 \times 10^{17}$ cm$^{-3}$ of B$^+$ (boron ions) is diffused as a p impurity is formed in the portion of substrate 11 that is below field insulation layer 12.

Unlike the structure in the device shown in Figs. 1(a) and 1(b), gate electrode 23 in this embodiment has a removed portion 23a in the vicinity of its centre. Removed portion 23a has the shape of a quadrilateral in the direction of disposition of source and drain regions 14 and 15. The length of removed portion 23a is shorter in the vicinity of the central portion of channel region 20 than at the channel region 20 portions which bound field insulation layer 12.

As a result of gate electrode 23 being made this shape, a large amount of gate current is produced and field concentration near the boundaries of channel region 20 and field insulation layer 12, where it is most liable to occur, is suppressed, since gate electrode 23 is made longer in these portions. As a result, reliability is improved. At the same time the effective channel length is shortened, since gate electrode 23 is shorter in the vicinity of the central portion of channel region 20. In other words, the device of this embodiment makes it possible to maintain satisfactorily high reliability despite shortening of the effective channel length.

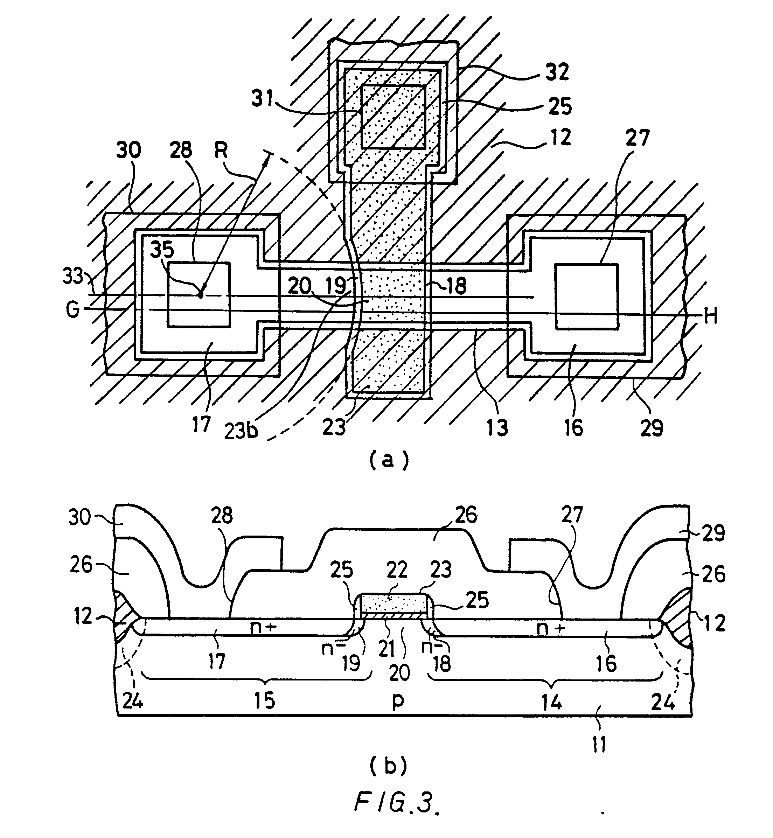

Fig. 3 shows the structure of another embodiment of a MOS semiconductor device according to the invention. Fig. 3(a) is a plan view of the pattern of this device and Fig. 3(b) is a section along the line G-H of Fig. 3(a). In the description of this device, those parts which are the same as in Fig. 2 will be identified by the same reference numbers.

In the figure, for example, a p type (100) silicon semiconductor substrate 11 has a resistivity of 0.3 (ohm.cm).

An element region 13 is isolated by a field insulation layer 12 of about 5000 (Angstrom) thick. A source region 14 and a drain region 15 are each formed by $n^+$ regions, 16 and 17, with a comparatively high impurity concentration, e.g., about $1.6 \times 10^{20}$ cm$^{-3}$, and an $n^-$ region, 18 and 19, with a comparatively low impurity concentration, e.g., about $2 \times 10^{18}$ cm$^{-3}$. N$^-$ regions 18 and 19 are formed so that they are adjacent a channel region 20 defined between source region 14 and drain region 15. A very thin, e.g., about 200 (Angstrom), gate insulation layer 21 is formed on top of channel region 20 by thermal oxidation of silicon or similar procedure. A gate electrode conductor 22 is formed on top of gate insulation layer 21. Gate electrode conductor 22 is constituted by polycrystalline silicon that has a layer thickness of around 4000 (Angstrom) and is made low-resistance by the inclusion of an impurity. Gate insulation layer 21 and gate electrode conductor 22 together form a gate electrode 23 with a stack structure. An anti-inversion layer 24 in which around $1 \times 10^{17}$ cm$^{-3}$ of B$^+$ is diffused as a p impurity is formed in the portion of substrate 11 that is below field insulation layer 12. A silicon insulation layer 25 formed by CVD (chemical vapour deposition) is deposited on the side wall of gate electrode 23.

A silicon oxide layer 26 as an insulation layer is deposited on substrate 11 and contact holes 27 and 28 are opened in silicon oxide layer 26 to the surfaces of n+ regions 16 and 17. An aluminium source electrode 29 and a drain electrode 30 are respectively connected to source and drain regions 14 and 15 through contact hole 27 and contact hole 28. Further, a contact hole 31 is opened through gate electrode conductor 23 in a location that is away from channel region 20. An aluminium gate lead 32 is connected to gate electrode 23 in contact hole 31.

Unlike the structure in the device of the embodiment described earlier, gate electrode 23 in the device of this embodiment has an arc-shaped portion 23b Arc-shaped portion 23b is removed in a manner such that the part where the arc-shaped portion goes deepest into the channel region 20 side is in the vicinity of the central portion of channel region 20. In this case, the shape of the portion of gate electrode 23 on the drain region 15 side is an arc that has a radius R of 5 ($\mu$m) and has a central axis 35 on an extension of a segment 33 through the centre of the channel width and towards drain region 15. The length of gate electrode at the central portion of channel region 20 is 2 ($\mu$m). The length of gate electrode 23 at the boundaries with field insulation layer 12 is about 2.1 ($\mu$m).

In the device of this embodiment, in the direction of disposition of the source and drain regions, the length of gate electrode 23 is shorter in the vicinity of the central portion of channel region 20 than it is at boundaries with field insulation layer 12. For the same reasons as noted above, improvement of reliability is achieved together with shortening of the effective channel length. Therefore, the device of this embodiment too makes it possible to maintain satisfactorily high reliability even though the effective channel length is made shorter.

The procedure for forming source and drain regions 14 and 15 in the device of this embodiment is as follows. Gate electrode 23 is formed prior to deposition of silicon oxide layer 25 on its side wall. N impurity is diffused using gate electrode 23 and field insulation layer 12 as a diffusion mask. Then, silicon insulation layer 25 is deposited on the side wall of gate electrode 23 and impurity is diffused again. As a result, the regions in which impurity is diffused twice constitute n+ regions 16 and 17. The regions, in which the impurity is diffused once, constitute n⁻ regions 18 and 19. The diffusion depth in each region at this time is about 0.3 ($\mu$m).

Gate electrode 23 in the embodiment of Fig. 2 or Fig. 3 can be shaped simply by changing the PEP (photetching process) mask pattern. The manufacturing process is the same as that for a conventional process.

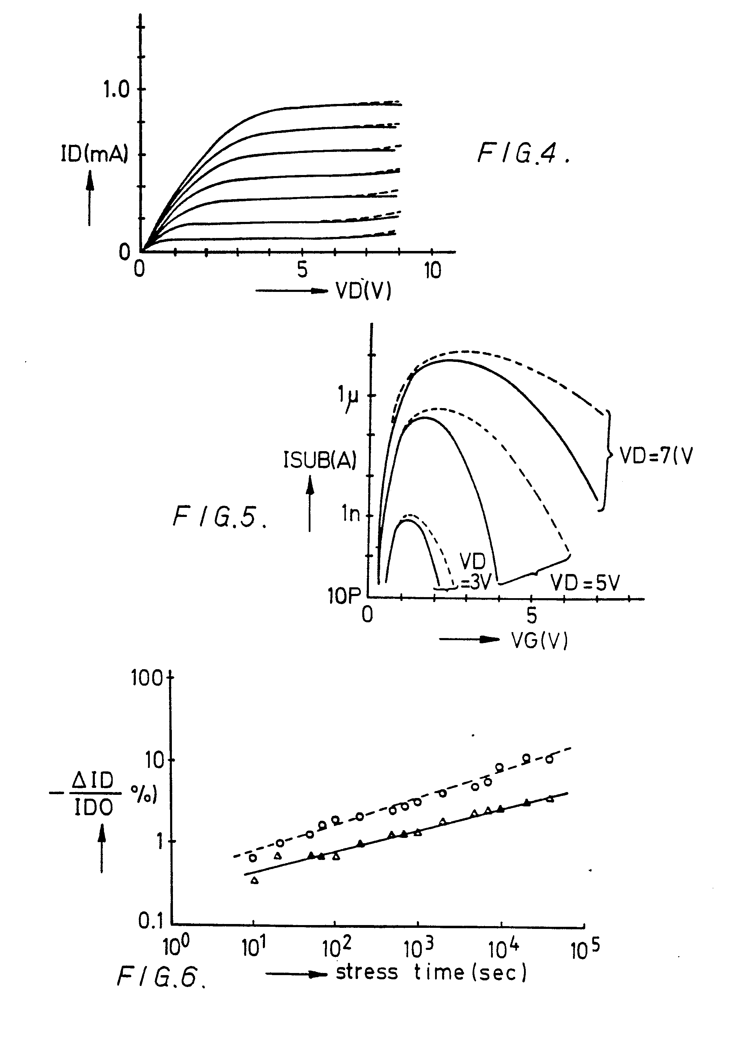

Figs. 4 through 6 are characteristic plots that contrast various electrical properties of the MOS semiconductor device of the embodiment of Fig. 3 with those of a conventional device. The gate electrode length above the channel region in the conventional device is taken to be a uniform 2 ($\mu$m).

Fig. 4 has MOS drain voltage VD (V) on the abscissa and drain current ID (mA) on the ordinate and shows the drain characteristic when the gate voltage VG is changed in steps of 1 V. The full lines in the figure are curves of the device of the invention and the dashed lines are curves of the device shown in Figs. 1(a) and 1(b). It is seen that there are hardly any differences in the drain characteristic.

In Fig. 5, MOS transistor gate voltage VG (V) is on the abscissa and substrate current ISUB (A) which flows into the substrate is on the ordinate. The figure shows the substrate current characteristic on variation of the drain voltage VD (V). As shown in Fig. 5, the full lines are curves of the device of the invention and the dashed lines are curves of the conventional device. It is seen that over the entire VG voltage range there is less production of substrate current in the device of the invention. This tendency is particularly so when the value of VG is large. The substrate current is a measure of the amount of hot electrons injected, since when it is small the gate current too is proportionally small.

Fig. 6 shows reliability in a stress environment. The abscissa plots stress time (sec) and the ordinate the variation (%) of the reduction - $\Delta$ ID of drain current relative to the initial drain current value IDO. In this case, too, the full line is the curve of the device of the invention and the dashed line is the curve of the conventional device. It is seen that the change of drain current with time falls together with the reduction of the substrate current shown in Fig. 5.

Thus, by partially changing the shape of gate electrode 23, the device of the invention gives much improved electrical characteristics relating to substrate current and timewise changes of drain current, etc. Further, by optimization of the drain region's n⁻ region width and impurity concentration and the gate electrode length in the channel region central portion, one can produce a MOS transistor which, conversely to the above, has the same degree of reliability as a conventional device but has improved current drive performance representing the drain characteristic. Such optimization can also reduce the area occupied by the element.

As described above, the invention makes it possible to provide a MOS semiconductor device permitting maintenance of satisfactorily high reliability even if the effective channel length is reduced.

In the MOS semiconductor device of the invention, there is considerable gate current and the length of the gate electrode in the vicinity of boundaries with the field insulation layer which is where field concentration is more liable to occur, is made long, so suppressing electric field concentration in these areas and improving reliability, while at the same time the gate length in the vicinity of the central portion of the channel region is made shorter so as to give a shorter effective channel length.

Desirably, the ratio of the lengths of the gate electrode 23 and the channel region 20 in the vicinity of the central portion of the channel region 20 to the lengths of the gate electrode 23 and the channel region 20 in the vicinity of the channel region 20 bounding the element separation region 12 is approximately 9 to 10.

## Claims

1. An MOS semiconductor device comprising:
a semiconductor substrate (11); and
a MOS transistor having a pair of impurity diffusion regions which are separated from one another in the semiconductor substrate (11) and constitute source and drain regions (14, 15) separated by a channel region (20), and a gate electrode (23) constituted by a stack structure consisting of a gate insulation layer (21) and a gate conductive layer (22), the MOS transistor being surrounded by an element separating region (12); characterised in that
the lengths of the gate electrode (23) and the channel region (20) between the source and drain regions (14, 15) in the vicinity of a central portion of a channel region (20) are shorter than the lengths of the gate electrode (23) and in the channel region (20) in the vicinities of channel region (20) bounding the element separation region (12).

2. An MOS semiconductor device as claimed in claim 1, characterised in that at least the drain region (15) of the MOS transistor is constituted by first and second impurity diffusion regions of relatively high and low impurity concentrations resepctively and the second impurity diffusion region is formed adjacent the channel region (20).

3. An MOS semiconductor device as claimed in claim 1 or claim 2 characterised in that a portion of the gate electrode (23) in the vicinity of the central portion of the channel region (20) facing the drain region (15) is cut away.

4. An MOS semiconductor device as claimed in claim 3 characterised in that the removed portion (23a) has a constant length in the direction between the source and drain regions (14, 15).

5. An MOS semiconductor device as claimed in claim 3 characterised in that removed portion (23b) has an arcuate edge.

6. An MOS semiconductor device as claimed in claim 5 characterised in that the arcuate edge has its centre (35) on a central axis (35) of the channel region (20).

7. An MOS semiconductor device as claimed in any of claims 1 to 6 characterised in that the ratio of the lengths of the gate electrode (23) and the channel region (20) in the vicinity of the central portion of the channel region (20) to the lengths of the gate electrode (23) and the channel region (20) in the vicinity of the channel region (20) bounding the element separation region (12) is approximately 9 to 10.

**53**

**42**

**50**

**L**

A ——————————————————————————— B

**49**

**48**

**47**

**46** **43**

(a)

**53** { **52** **51** }

n−

**42**

n+ n+ **42**

**47** **49** **50** n− **48** **46**

**54** **45** **44** **54**

p

**41**

(b)

*FIG.1.*

PRIOR ART

**23**

**23a**

**12**

**13**

C ———————————————————————— D

**20**

E ———————————————————————— F

**19**

**18**

**17**

**16**

(a)

22 } 23
21 }

12 — n+ — n+ — 12

17  19  20  18  16
24
15  n- p  n-  14
11

(b)

22 } 23
21 }

12 — n+ — n+ — 12

17  19  20  18  16
24  24
15  n- p  n-  14
11

(c)

*FIG.2.*

( a )

( b )

FIG.3.

FIG.4.

FIG.5.

FIG.6.